# EUROPEAN PATENT SPECIFICATION

(11) **EP 2 630 652 B1**
(45) Date of publication and mention of the grant of the patent: **29.07.2020**
(21) Application number: 11835066.9
(22) Date of filing: 19.10.2011
(51) Int. Cl.: H01K 3/10, H05K 3/42

(54) **METHOD OF MANUFACTURING PRINTED CIRCUIT BOARDS HAVING VIAS WITH WRAP PLATING**
VERFAHREN ZUR HERSTELLUNG BESTÜCKTER LEITERPLATTEN MIT DURCHGÄNGEN MIT RUNDUMPLATTIERUNG
PROCÉDÉ DE FABRICATION DE CARTES DE CIRCUIT IMPRIMÉ COMPORTANT DES TROUS D'INTERCONNEXION AVEC DÉPÔT PAR ENROULEMENT

(30) Priority: 19.10.2010 US 394672 P
(43) Date of publication of application: 28.08.2013
(73) Proprietor: Viasystems, Inc., St. Louis, MO 63105 (US)
(72) Inventor: SORENSEN, Adam, San Leandro, CA 94579 (US); LEWIS, Bruce, San Jose, CA 95135 (US)
(74) Representative: Greaves Brewster LLP
(86) International application number: PCT/US2011/056881
(87) International publication number: WO 2012/054599

(56) References cited:
- EP-A1- 0 809 424
- EP-A1- 2 094 068
- US-A- 4 017 968
- US-A- 5 050 295
- US-A- 5 362 534
- US-A- 5 406 034
- US-A- 6 009 620
- US-A1- 2005 204 550
- US-A1- 2007 068 700

## Description

### FIELD OF INVENTION

The present invention relates generally to a method for producing multilayer printed circuit boards having at least one electrically conductive via. The invention relates more specifically to an improved method for producing a circuit board with at least one via having wrap plating.

### BACKGROUND OF THE INVENTION

The multi-layered printed wiring or circuit board ("PCB") found in modern electronic devices includes one or more paired circuit layers. Each paired circuit layer includes an insulating core layer, which is also referred to as a carrier or base material. The core layer includes opposing first and second surfaces on which are disposed electronic circuits. These electronic circuits are typically formed and patterned so as to receive electronic components by way of pads or interconnections. The paired circuit layers are formed by laminating the insulating core with a first foil layer on both the first side of the core and on the second side of the core. The laminated core is processed (plated and etched) so as to form circuit traces and pads on the outside surfaces of the laminated core. The resulting insulating substrate sandwiched between the pair of opposing circuit layers can be used to form a sub-element (of paired circuit layers) in a multi-layer printed circuit board.

In a multi-layer printed circuit board, the paired circuit layers (sandwich arrangement) described above constitutes a sub-element that is stacked with one or more other sub-elements to form the multi-layer printed circuit board. The plurality of paired circuit layers are physically and electronically joined to form the board. Such a multi-layer printed circuit board is created by placing a dielectric layer (often prepreg or other suitable insulating adhesive) between sub-elements and stacking the sub-elements with the dielectric layer in between in a press. The dielectric layer is typically heat curable or provided with an adhesive. After allowing the dielectric and/or adhesive to cure, a multi-layer substrate comprising the plurality of paired circuit layers is formed. In the substrate, the dielectric layers are interposed between the paired circuit layers (sub-elements). The substrate has a first side in opposite relation to a second side.

One method of manufacturing a PCB involves laminating the substrate comprising the one or more paired circuit layers with a first foil layer on the first side of the substrate and on the second side of the substrate. Each conductive foil, which is usually made from copper, may, in turn, comprise one or more layers. The foil layer applied to each side of the substrate is adhered to the substrate using lamination processes well-known in the art. Such lamination processes typically involve applying an adhesive (prepreg or bond ply) to both major surfaces of the substrate and then applying a foil layer to each surface to form a foil-substrate-foil stack. The foil layers stacked with the substrate there-between are placed in a press and allowed to cure. The end result of the initial lamination process is a foil-laminated substrate.

After forming the foil-laminated substrate, one or more via holes are drilled into one or both side surfaces of the foil-laminated substrate. The one or more via holes have opposite ends. The sidewall of the one or more via holes are then plated with a conductive material so as to provide conductive interconnection among the circuit layers. In a multi-layer PCB, a via may extend from one outside surface of the PCB, through the entire stack of circuit layers and to the opposing outside surface of the PCB. Alternatively, in a multi-layered PCB, the via may be a blind or buried via.

For clarity sake, the term "via" is used in this application to refer to the plated though-hole structure after processing as herein described. The term "via-hole" is used to refer to the hole structure that is involved in the PCB formation processing steps herein described. Thus, as used herein a via-hole is an unfinished via. In one PCB manufacturing method, the via hole that will form the via is formed in the laminated substrate after the lamination step described above. A via hole is conventionally formed by mechanical or laser drilling. After the via hole is formed in the laminated substrate, the foil-laminated substrate is plated (typically by way of electroless plating) in order to add (metalize) a first conductive layer to the sidewall of the via hole. An image dot or button pattern is then applied to the surfaces of the foil-laminated substrate so that button plates may be formed around the via hole. The foil-laminated substrate will thereafter undergo successive preparation and plating steps along with filling of the via hole in order to form the eventual printed circuit board.

Filling the via hole enhances the electrical performance of the PCB and may improve structural reliability of the eventual via. At what stage the via hole is filled during the PCB manufacturing process depends upon the manufacturer. In one exemplary process involving conductive ink fill material, the via hole is filled with the desired fill material after adding the first conductive layer upon the sidewall of the via hole. The fill material is allowed to cure. The ends of the filled via hole are then planarized, a process that often entails removal of the surface of the button plate. After this last step, the panel undergoes further imaging and another conductive layer is added over both sides of the foil-laminated substrate, including over the ends of the filled via hole, thus forming the via.

Connectivity and reliability problems occur in PCBs having ink-filled vias manufactured in accordance with known methods, such as described above. These problems will usually manifest when components are applied to the finished PCB. In this regard, the conductive layer or cap applied to the top of the via separates from the copper-plated (metalized) walls of the via.

Various PCB production methods have been developed to combat the wall-surface conductor separation described above. These methods are directed to improving the "wraparound plating" of the PCB. This "wraparound plating" or "wrap" refers to the conductive material applied to the PCB in the area surrounding (i.e., wrapping around) the via hole. The wrap area is often referred to as "additive wrap" by virtue of the sequential plating steps required to create the wrap area. By thickening the wraparound plating, the propensity of the conductor on the sides of the via to separate from the surface conductor is reduced. However, simply thickening the wraparound plating does not completely eliminate surface conductor separation from the metalized via walls. In fact, such thickening of the wraparound plating may contribute to PCB unreliability due to inconsistent plating thickness distribution on the surface of the laminated substrate or due to inconsistent planarization after the via fill process. The successive plating steps in PCB manufacture may also cause over-thickening of the plating over the via and via wrap. Such over-thickening is undesirable in that it can cause issues due to the ever-increasing density of circuit traces and components on the surfaces of the PCB.

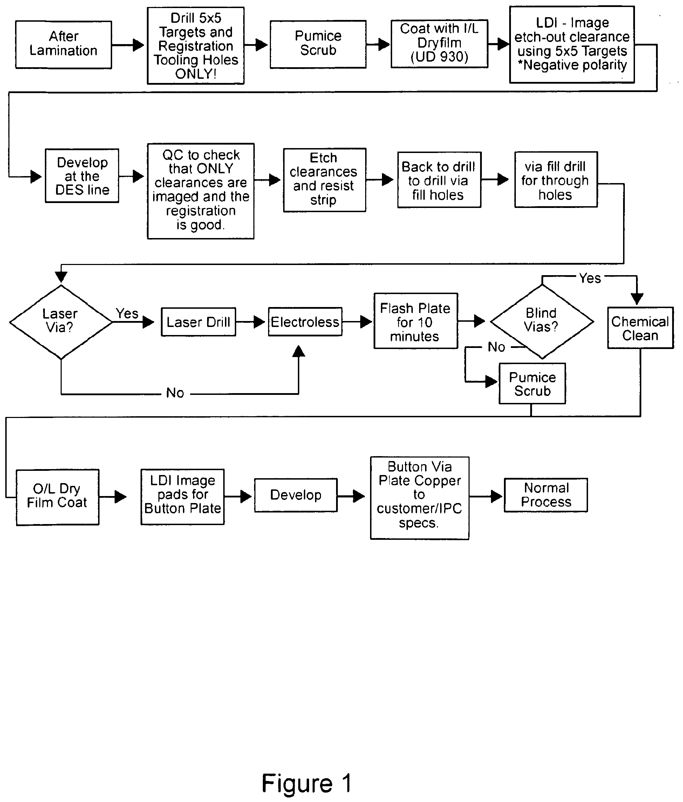

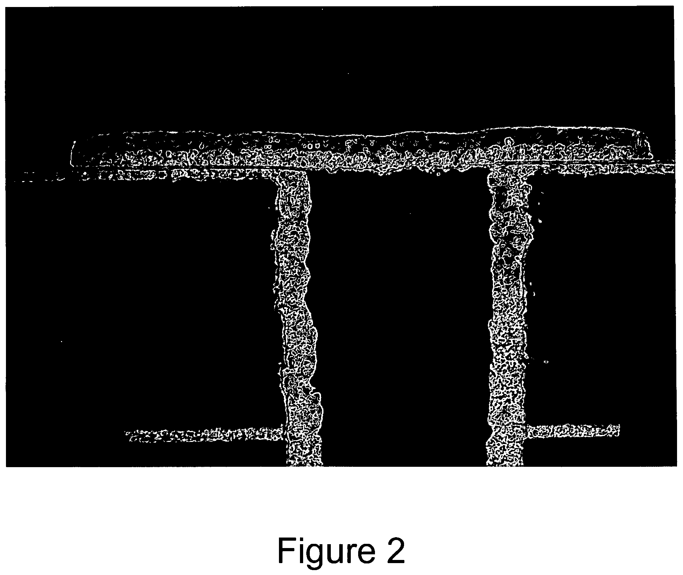

One method of reducing the problems associated with thickened wrap-around plating involves etching clearances in the foil or conductive layers around the via hole during the PCB production process. FIG. 1 shows a process flow chart for forming a via in accordance with known methods. In the process, a circular clearance is etched in the foil layer of the foil-laminated substrate at the situs where a via hole will be drilled. The clearance is larger in diameter than the diameter of the intended via hole. Hence, after the via hole is drilled in the cleared area, a via hole with a stepped rim results. The inner part of the rim (the "inner rim") is formed from the insulating adhesive that bonds the foil layer to the substrate. This inner rim is located below the surface of an outer rim, which is formed by the foil layer. By etching a clearance around the via hole, over-thickening of the plating and the problems associated therewith can be reduced. FIG. 2 shows a via formed in accordance with such a clearance etching method.

There are, however, disadvantages to clearance etching to achieve via wrap integrity. Current methods to achieve a quality via wrap and etch fine features generally result in relatively great amounts of material loss in the form of scrap. This loss arises from the need to successively panel plate the foil-laminated substrate to form the wrap. High scrap loss translates into higher production costs to the manufacturer and ultimately higher PCB costs to the customer. In addition to scrap loss, such panel plating creates uneven surface copper that forces the PCB manufacturer to selectively etch areas that are uneven. What is needed then is an improved PCB manufacturing process that results in a high-quality via wrap without the disadvantages of methods relying on clearance etching and the associated successive plating. The prior art comprises the documents EP-A1-0809424, EP-A1-2094068, US-A1-2007068700.

### SUMMARY OF THE INVENTION

According to one embodiment of the invention, a method for the production of a PCB with at least one electrically conductive via comprises laminating a substrate (comprising one or more stacked circuit layer pairs) with a first foil layer on the first side of the substrate and on the second side of the substrate. A via hole is then formed in the first side of the foil-laminated substrate. (It may also be formed in the second side of the foil-laminated substrate.) The via hole has a first end and second end. The first end of the via hole is formed in the foil layer on the first side of the foil-laminated substrate. The via hole extends from the first foil layer on the first side of the laminated substrate through to at least one circuit layer of the foil-laminated substrate. In contrast to prior art methods, the first end of the via hole formed in the first foil layer is countersunk to form a beveled opening at the surface. The countersinking of the via hole angularly removes the foil layer (surface copper) from around the hole opening. In one embodiment of the present invention process, in addition to the first foil layer, some material underlying the foil layer is removed during the countersinking process. In one embodiment of the present invention, the via hole extends from the first foil layer on the first side of the laminated substrate, through the stacked circuit layer pairs and through the first foil layer on the second side of the foil-laminated substrate. In such an embodiment both ends of the via hole may be countersunk as herein described.

After countersinking, the via hole is then prepared for plating. For example, after preparation, the sidewall of the via hole and the countersunk surfaces are coated with a conductive material, preferably by electroless copper or other conductive film. After the conductive coating is applied to the sidewall of the via hole and the one or more countersunk surfaces, the laminated substrate may be processed in accordance with conventional techniques. In this regard, the laminated substrate may be flash plated for a short period of time (e.g., about ten minutes) to set the conductive coating. The panels may have an image button pattern applied and be electro-plated to add button plate copper according to customer specification.

Via holes formed in accordance with the present invention process can be filled with either non-conductive or conductive material. The process provides for tight lines and spacing by removing the panel plate process from the initial steps of PCB formation. Additionally, the process allows base foil to be untouched by secondary plating, thus allowing the conductive layer to remain consistent and uniform throughout the panel. This in turns allows consistent etching of fine features across the panel. The present invention process also allows better etching of full body gold panels that require non-conductive or conductive via fill by having a thinner base foil by virtue of there being less gold slivers from etching. In addition to the described process, the invention includes a laminated substrate and a PCB having features formed by the described process.

### BRIEF DESCRIPTION OF THE DRAWINGS

The accompanying drawings, together with the specification, illustrate exemplary embodiments of the present invention, and, together with the description, serve to explain the principles of the present invention. Unless otherwise stated, the depicted embodiments are not intended to limit the overall invention to the specific embodiment.
FIG. 1 depicts the process flow for a prior art method for forming wraparound plating.
FIG. 2 depicts a via having an additive wrap plate formed in accordance with prior art methods. The via is filled with non-conductive ink material.

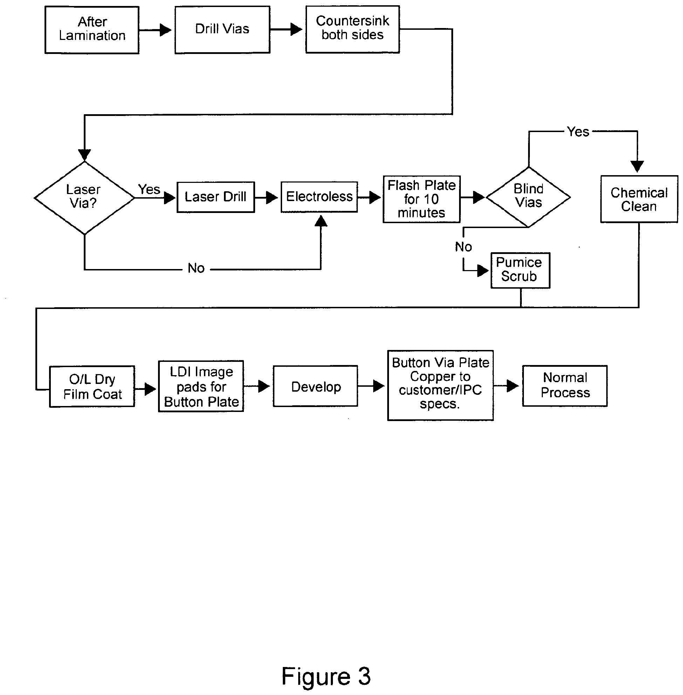

FIG. 3 depicts the process flow for one embodiment of the present invention method for forming a via with wraparound plating.
FIG. 4 depicts a plated via hole having wraparound plating formed in accordance with the present invention method. The via hole is filled with non-conductive ink material.
FIG. 5 is an enhanced view of the via hole shown in FIG. 4 and shows in better detail the wrap area of the via hole where the plating of the beveled sidewall surface at the end of the via hole joins the foil layer.
FIG. 6 is a further enhanced view of the via hole shown in FIG. 4 and shows in even greater detail the wrap area of the via hole where the plating of the beveled sidewall surface at the end of the via hole effectively interlocks with surface copper.
FIGS. 7A through 7D are views illustrating preferred embodiment angles and dimensions for a via hole formed in accordance with the present invention.
FIG. 8 depicts a via having wraparound plating formed in accordance with the present invention method and having a conductive capture pad.

### DETAILED DESCRIPTION OF THE INVENTION

In the following detailed description, only certain exemplary embodiments of the present invention have been shown and described, simply by way of illustration. As those skilled in the art would realize, the described embodiments may be modified in various different ways, without departing from the scope of the present invention. Accordingly, the drawings and description are to be regarded as illustrative in nature and not restrictive.

In the context of the present invention, the term "via" includes through-vias, blind vias, buried vias, and micro-vias. According to one embodiment of the invention, a method for the production of a PCB with at least one electrically conductive via comprises laminating a substrate **1** having one or more stacked circuit layer pairs with a first foil layer **2** on each of the first side **10** of the substrate and the second side **20** of the substrate. In an embodiment of the present invention, the starting surface copper foil layer **2** can be chosen from any suitable thickness. A via hole **3** having first and second opposing ends **4, 5** and a sidewall **12** is then formed in the foil-laminated substrate. The first end **4** of the via hole **3** is formed in the first foil layer **2** on the first side of the substrate and on into the substrate. The via hole **3** extends from the first foil layer **2** on the first side **10** of the foil-laminated substrate through to at least one circuit layer of the foil-laminated substrate. The first end **4** of the via hole **3** located on the first side of the foil-laminated substrate is then precision countersunk to form a "V-shaped" or beveled opening at the foil surface. The countersinking of the via hole **3** angularly removes the foil layer (surface copper) from around the hole opening **9** and provides the via hole **3** with a beveled sidewall surface **6** at its first end **4**. This beveled sidewall surface **6** creates a relief **7** at the end of the via hole **3**. In one embodiment of the present invention process, in addition to the first foil layer **2**, some insulating material **8** underlying the foil layer **2** is removed during the countersinking process. In an alternate embodiment of the present invention, the via hole **3** extends from the first foil layer **2** on the first side **10** of the laminated substrate, through the stack of circuit layer pairs and through the first foil layer **2** on the second side **20** of the foil-laminated substrate. In such an embodiment the second end **5** of the via hole **3** is formed in the foil layer **2** on the second side of the substrate allowing both ends **4, 5** of the via hole **3** to be countersunk as herein described.

After countersinking the at least one via hole **3**, the laminated substrate **1** is then processed in accordance with known methods. For example, after countersinking, the via hole **3** is prepared for coating. Next, the sidewall **12** of the hole and the beveled sidewall surface **6** (or surfaces in the case of a through via hole) are coated with a conductive material **15**, preferably by electroless copper or other conductive film. After the conductive coating is applied to the sidewall **12** of the hole and the beveled surface(s) **6**, the foil-laminated substrate may be processed in accordance with conventional techniques. In this regard, the foil-laminated substrate may be flashed plated for a short period of time (for example, ten minutes) to set the conductive coating. The foil-laminated substrate is then coated with a resist and imaged with the intention of developing clearances. The foil-laminated substrate is then plated to the desired copper thickness. The resist is stripped and the foil-laminated substrate is then planarized.

The countersinking of the via hole **3** provides a clearance **16** that when plated and planarized creates a via wrap that meets IPC requirements for wrap specification. Additionally, the plating **15** extending from the beveled sidewall surface **6** of the via hole **3** is contiguous with the surface copper **2** per the specification. The countersink clearance (the distance between the outer diameter of the countersunk hole and the sidewall of the via hole) **16** is precision positioned by hole location and creates optimal registration of clearance-to-hole location. The present invention process can reduce the number of panel plate steps normally required to form the wrap. This reduction results in finer lines and spaces as images are formed on non-plated up copper foils. This in turn results in more consistent and uniform etching of tight and small features. The present invention thus eliminates the added plated copper thickness over the surface copper and provides more consistent wrap plating thickness on the entire surface of the printed circuit board. This helps to hold in place the bond between the surface conductor copper and the plated via hole wall copper while making it now possible to manufacture boards with finer features and tighter geometries.

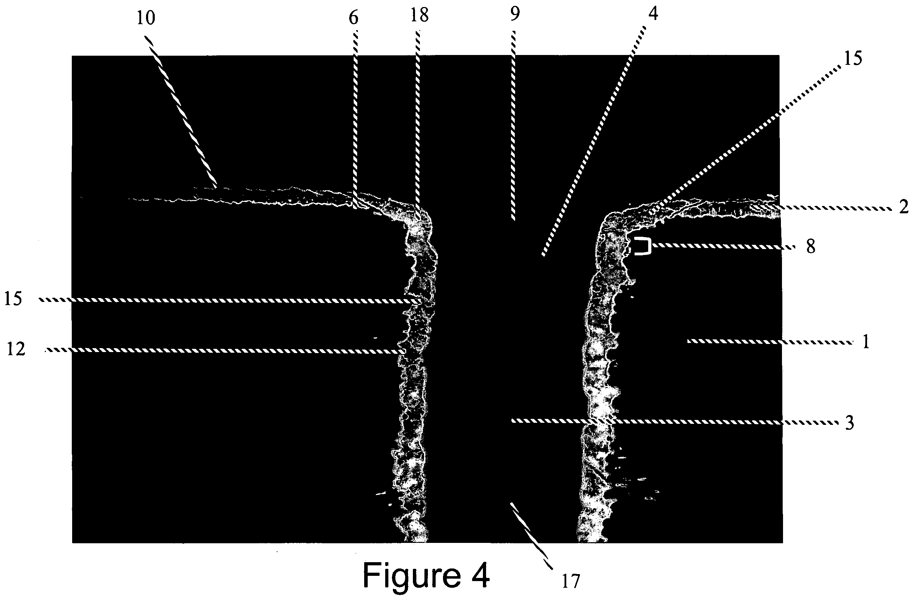

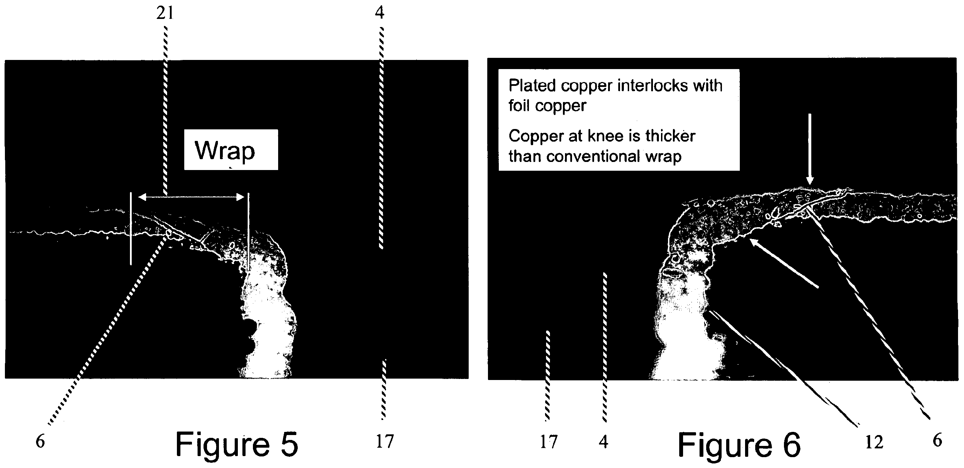

FIGS. 4, 5 and 6 depict a plated via hole **3** having wraparound plating **21** formed in accordance with the present invention method. The via hole **3** can be filled with conductive or non-conductive ink material **17**. Another advantage of the present invention process results from the fact that the knee **18** of the via hole (including the beveled sidewall surface) is angled in such a way, that when plated, the knee may have as much or more copper than the sidewall of the via hole. This is in contrast to current processes, where after planarizing the plating on the knee is usually thinned to a thickness half that of the via hole sidewall (See FIG. 2). In addition, as shown in FIGS. 4, 5 and 6, the copper wrap **21** from the via hole wall **12** and extending on to the beveled surface **6** interlocks with the copper foil 2 on the surface of the laminated substrate for better bonding. By integrating the novel countersinking step into the panel preparation process, the overall process requires less processing steps than current methods. In particular, the panel preparation process does not include the imaging and etching steps required to selectively etch copper from around the via hole.

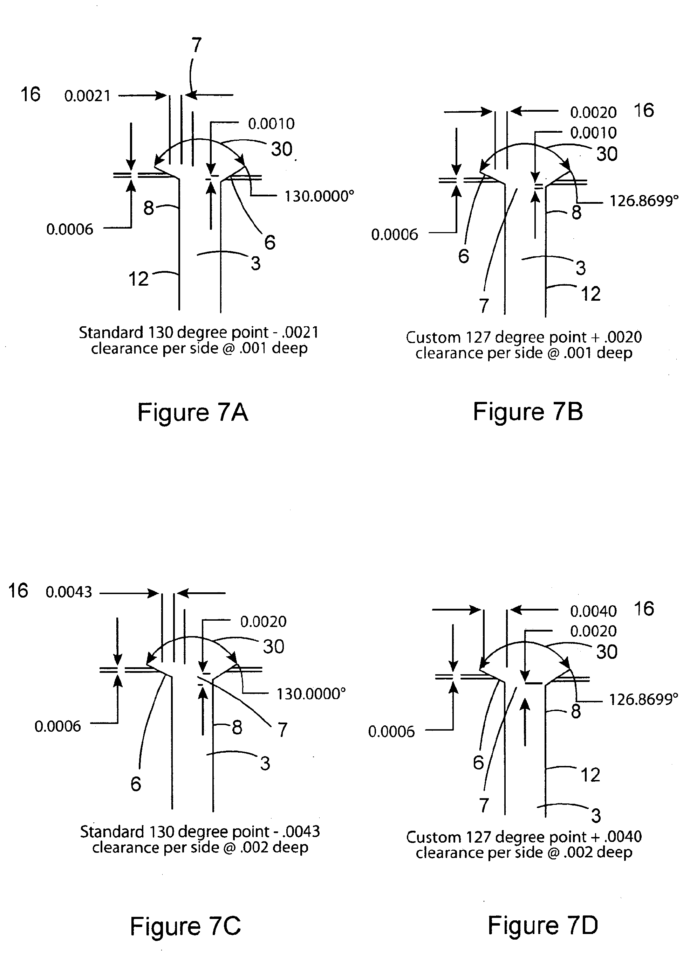

FIGS. 7A through 7D illustrate embodiment angles and dimensions for a via hole **3** formed in accordance with the present invention with an embodiment foil layer of about 0.0006 inches. In one embodiment of the present invention, the hole is countersunk to a depth of about 0.001 inches using a 130-degree drill point. This embodiment results in about a 0.0021-inch clearance **16** around the hole as measured from the inside (unplated) wall **12** of the hole. In another embodiment of the present invention, the hole is countersunk to a depth of about 0.002 inches using a 130-degree drill point. This embodiment results in about a 0.0043-inch clearance **16** around the hole as measured from the inside (unplated) wall **12** of the hole. In another embodiment of the present invention, the hole is countersunk to a depth of about 0.001 inches using a 127-degree drill point. This embodiment results in about a 0.002-inch clearance **16** around the hole as measured from the inside (unplated) wall 12 of the hole. In another embodiment of the present invention, the hole is countersunk to a depth of about 0.002 inches using a 127-degree drill point. This embodiment results in about a 0.004-inch clearance **16** around the hole as measured from the inside (unplated) wall **12** of the hole.

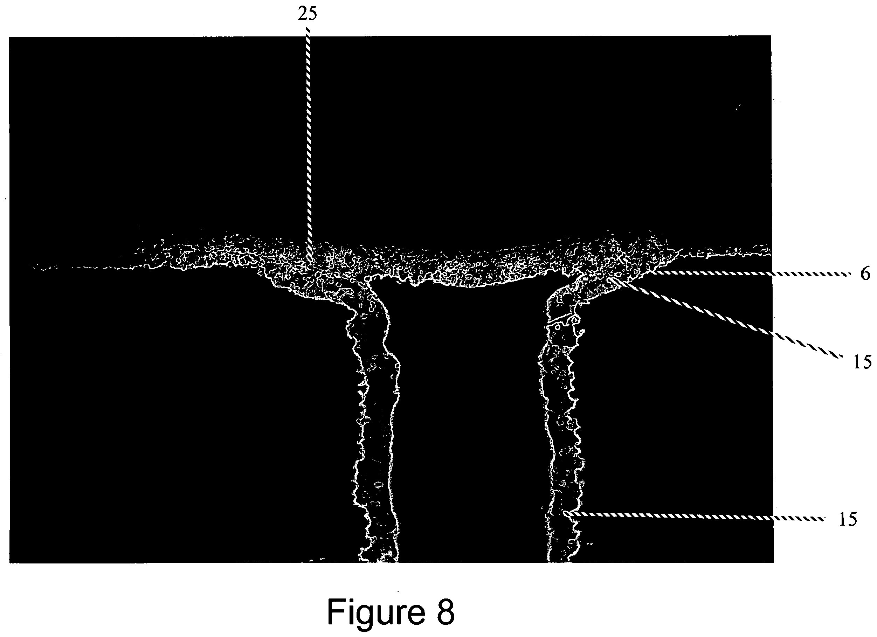

By removing the clearance etching steps, the present invention process eliminates completely the problems associated with locating via holes in the etched clearances. Furthermore, the via holes may be drilled and countersunk in one step, allowing precise registration of the clearances with the via holes. Thus the step of clearance formation can be combined with the step of via hole drilling. FIG. 8 depicts a preferred embodiment completed via formed in accordance with the present invention method and having a capture pad (conductive cap) **25**. As shown by FIG. 8, the present invention process also reduces or eliminates the high button plates that result from the successive plating steps of current PCB production processes. Yet, production of prototypical PCBs has shown that the process results in a greater amount of copper in the connection between the capture pad and the via, which results should in turn lead to higher reliability of the joint. In addition, by using the countersink process as herein disclosed, the end-result capture pad **25** has a slight concave curvature **26** in its pad surface **27**. This curvature **26** enhances chip soldering by allowing the pad curvature **26** to cradle the solder ball of the chip.

The present invention further includes a printed circuit board (PCB) comprising a first outer surface circuit layer in opposing relation to a second outer surface circuit layer. The PCB further includes one or more internal circuit layers disposed in stacked formation between the first outer surface circuit layer and the second outer surface circuit layer. The PCB includes at least one via. The at least one via has a sidewall **12**, a first end **4** and a second end 5**.** The sidewall **12** has conductive plating **15**. The sidewall plating **15** at the first end **4** of the via **3** is beveled (formed on beveled surface **6**) and is in electrical contact with the first outer surface circuit layer **2**. The via extends from the first outer surface circuit layer of the PCB through to at least one of the one or more internal circuit layers. In an alternate embodiment of the present invention PCB, the via extends from the first outer surface circuit layer on the first side of the laminated substrate, through the entirety of stacked internal circuit layer pairs such that the second end **5** of the via extends to, and is formed in, the second outer surface circuit layer. In such an embodiment, the sidewall plating **15** at the second end of the via is beveled (formed on beveled surface **6**) and is in electrical contact with the second outer surface circuit layer.

The present invention further includes a foil-laminated substrate **1** comprising at least one countersunk via hole **3**. The foil-laminated substrate includes a substrate **1** having one or more circuit layer pairs in stacked formation. The substrate has a first side **10** and a second side **20**. The first and second sides of the substrate correspond to the first and second sides of the foil-laminated substrate. The foil-laminated substrate includes a foil layer **2** laminated to each of the first and second sides of the substrate. The foil-laminated substrate also further includes at least one via hole **3** in the foil-laminated substrate. The via hole **3** has a first end **4** and a second end **5**. The first end **4** of the via hole **3** extends from the first foil layer **2** on the first side of the foil-laminated substrate through to at least one circuit layer of the foil-laminated substrate. The sidewall **12** at the first end **4** of the via hole **3** has a beveled surface **6** that meets the foil layer **2** surface. The beveled sidewall surface **6** at the first end **4** of the via hole **3** comprises the foil layer. In one embodiment of the present invention laminated substrate, the beveled surface **6** at the first end **4** of the via hole **3** comprises insulating material **8** in addition to the foil layer **2.** In an alternate embodiment of the present invention, the via hole **3** extends from the first foil layer **2** on the first side **10** of the laminated substrate, through the stack of circuit layer pairs and through the first foil layer **2** on the second side of the foil-laminated substrate. In this embodiment, the second end **5** of the via hole **3** is formed in the foil layer **2** on the second side **20** of the foil-laminated substrate and has a beveled opening at the foil surface.

In a preferred embodiment of the foil-laminated substrate, the at least one via hole includes a first conductive layer **15** on the sidewall **12** and the beveled sidewall surfaces **6** of the at least one via hole. In an embodiment, the countersunk surfaces **6** of the via hole may comprise the first foil layer **2** and an insulating material **8**. In one embodiment of the foil-laminated substrate, the first conductive foil layer **2** has a thickness of about 0.0006 inches, the first end **4** of the via hole has a countersunk depth of about 0.001 inches and the angle **30** between countersunk surfaces **6** at the first end of the via hole is about 130 degrees. In another embodiment of the foil-laminated substrate, the first conductive foil layer **2** has a thickness of about 0.0006 inches, the first end of **4** the via hole has a countersunk depth of about 0.002 inches and the angle **30** between countersunk surfaces **6** at the first end of the via hole is about 130 degrees. In another embodiment of the foil-laminated substrate, the first conductive foil layer has a thickness of about 0.0006 inches, the first end of the via hole has a countersunk depth of about 0.001 inches and the angle **30** between countersunk surfaces at the first end of the via hole is about 127 degrees. In another embodiment of the foil-laminated substrate, the first conductive foil layer has a thickness of about 0.0006 inches, the first end of the via hole has a countersunk depth of about 0.002 inches and the angle 30 between countersunk surfaces at the first end of the via is about 127 degrees.

In view of the foregoing, embodiments of the present invention enhance the consistency of the wraparound plates of the vias of printed circuit boards to provide extra reliability to the printed circuit boards and enable the designers and/or manufacturers of printed circuit boards to design and manufacture boards with relatively fine features and/or tight geometries. In addition, the present invention enhances the consistency of the wraparound plates of vias of printed circuit boards to provide extra reliability to the printed circuit boards and enables the designers and/or manufacturers of printed circuit boards to design and manufacture boards with relatively fine features and tight geometries.

While the invention has been described in connection with certain exemplary embodiments, it is to be understood by those skilled in the art that the invention is not limited to the disclosed embodiments, but, on the contrary, is intended to cover various modifications included within the scope of the claims.

## Claims

1. A method of manufacturing a printed circuit board (PCB) comprising:
providing a foil-laminated substrate (1) having one or more stacked circuit layer pairs and comprising a substrate having first (10) and second (20) sides with a first foil layer (2) on each of the first side of the substrate and on the second side of the substrate, the first foil layers corresponding, respectively, to first and second sides of the foil-laminated substrate corresponding to the first and second sides of the substrate;
forming at least one via-hole (3) defined by a sidewall (12) in the substrate;
the at least one via-hole having opposing first (4) and second (5) ends with the first end extending through the first foil layer on the first side of the foil-laminated substrate;
the at least one via-hole extending from its first end in the first foil layer on the first side of the foil-laminated substrate through to at least one circuit layer of the foil-laminated substrate; and
countersinking (7) the first end of the at least one via-hole on the first side of the substrate through at least the first foil layer such that the sidewall at the first end of the via-hole has a beveled surface (6), wherein the countersinking (7) of the via-hole (3) comprises a clearance_(16) between an outer diameter of the countersink and the sidewall of the via hole; and
depositing a conductive layer (15) on the sidewall (12) extending onto the beveled surface (6) of the at least one via hole (3) such that the conductive layer interlocks with the first foil layer on the first side of the foil laminated substrate.

2. The method of Claim 1 further comprising:
forming the at least one via-hole (3) such that its second end extends through the first foil layer (2) on the second side (20) of the foil-laminated substrate (1); and
countersinking (7) the second end (5) of the at least one via-hole on the second side of the substrate through at least the first foil layer such that the sidewall at the second end of the via-hole has a beveled surface (6) wherein the countersinking (7) of the via-hole (3) comprises another clearance (16) between an outer diameter of the countersink and the sidewall of the via hole.

3. The method of Claim 1 wherein the beveled sidewall surface (6) comprises the foil layer (2).

4. The method of Claim 1 wherein the substrate (1) is laminated with the first foil layer (2) in a lamination step that includes use of a dielectric adhesive layer between the foil and the substrate and the beveled sidewall surface (6) comprises the foil layer and the dielectric adhesive layer.

5. The method of Claim 2 further comprising, depositing a first conductive layer (15) on the sidewall (12) and both beveled sidewall surfaces (6) of the at least one via-hole (3); and filling the at least one via-hole with a conductive (17) or non-conductive material (17) to form at least one filled via-hole.

6. The method of Claim 1 wherein the first foil layer (2) has a thickness of about 0.01524 mm (0.0006 inches) and the via-hole (3) is countersunk to a depth of about 0.00254 mm (0.001 inches) using a 130-degree (30) drill point.

7. The method of Claim 1 wherein the first foil layer (2) has a thickness of about 0.01524 mm (0.0006 inches) and the via- hole (3) is countersunk to a depth of about 0.00508 mm (0.002 inches) using a 130-degree (30) drill point.

8. The method of Claim 1 wherein the first foil layer (2) has a thickness of about 0.01524 mm (0.0006 inches) and the via- hole (3) is countersunk to a depth of about 0.00254 mm (0.001 inches) using a 127-degree (30) drill point.

9. The method of Claim 1 wherein the first foil layer (2) has a thickness of about 0.01524 mm (0.0006 inches) and the via- hole (3) is countersunk to a depth of about 0.00508 mm (0.002 inches) using a 127-degree (30) drill point.

10. The method of Claim 1 further comprising:
filling the at least one via- hole (3) with a conductive (17) or non-conductive material (17) to form at least one filled via-hole; and forming a conductive cap (25) over the first end of the at least one filled via-hole, the conductive cap being electrically connected with the conductive layer.

11. The method of Claim 10 further comprising:
forming a conductive cap over the first end of the filled via- hole (3), the conductive cap (25) being electrically in contact with the conductive layer (15); and
forming a conductive cap over the second end (5) of the filled via-hole, the conductive cap being electrically in contact with the conductive layer deposited on the sidewall and beveled sidewall surface of the second end of the at least one via-hole.

12. A printed circuit board (PCB) having a first side (10) and second side (20) comprising:
a first outer surface circuit layer on the first side of the PCB and in opposing relation to a second outer surface circuit layer on the second side of the PCB;
at least one internal circuit layer disposed in stacked formation between the first outer surface circuit layer and the second outer surface circuit layer;
at least one via- hole (3);
the at least one via-hole having a sidewall (12) extending between a first end (4) and a second end (5);
the sidewall at the first end of the at least one via-hole having a beveled surface (6), a countersinking (7) at the end of the via hole (3), the countersinking (7) comprising a clearance (16) between an outer diameter of the countersink and the sidewall of the via hole;
the at least one via-hole extending from the first outer surface circuit layer of the PCB through to at least one of the one or more internal circuit layers; and
a conductive layer (15) on the sidewall of the at least one via-hole including the beveled surface, the conductive layer being in electrical contact and interlocked with the first outer surface circuit layer on the first side of the PCB.

13. The PCB of Claim 12 wherein:
the at least one via-hole (3) extends from the first outer surface circuit layer of the PCB to and through the second outer surface circuit layer;
the sidewall (12) at the second end (5) of the at least one via-hole having a beveled surface (6) further comprising another clearance (16) about the second end of the at least one via-hole devoid of the second outer surface circuit layer; and
the conductive layer (15) is also on the beveled surface at the second end of the at least one via-hole, the conductive layer being in electrical contact with the second outer surface circuit layer.

14. A foil-laminated substrate (1) having first (10) and second sides (20) comprising:
a substrate having one or more circuit layer pairs in stacked formation disposed between a first side and a second side, the first and second sides of the substrate corresponding to the first and second sides of the foil-laminated substrate;
a first foil layer (2) laminated to each of the first and second sides of the substrate;
at least one via-hole (3) in the foil-laminated substrate;
the at least one via-hole having a first end (4) and a second end (5) and;
the first end of the at least one via-hole being in the first foil layer on the first side of the foil-laminated substrate;
the at least one via-hole extending from the first foil layer on the first side of the foil- laminated substrate through to at least one circuit layer of the foil-laminated substrate; and the first end of the at least one via-hole having a beveled sidewall surface that extends to the first foil layer; and
a conductive layer on the beveled sidewall surface of the at least one via hole to interlock with the first foil layer on the first side of the foil laminated substrate.

15. The foil-laminated substrate of Claim 14 wherein:
the first foil layer is laminated to the first (10) and second sides (20) of the substrate through use of a dielectric adhesive and the beveled surface at the first end (4) of the at least one via-hole comprises dielectric adhesive in addition to the foil layer;
the at least one via-hole extends from its first end formed in the first foil layer on the first side of the foil-laminated substrate, through the stacked circuit layer pairs, to its second end (5) formed in the first foil layer on the second side of the laminated substrate; and
the second end of the at least one via-hole has a beveled sidewall surface that extends to the first foil layer on the second side of the laminated substrate.

## Patentansprüche

1. Verfahren zur Herstellung einer Leiterplatte (PCB), umfassend:
Bereitstellen eines folienlaminierten Substrats (1) mit einem oder mehreren gestapelten Schaltungsschichtpaaren und umfassend ein Substrat mit erster (10) und zweiter (20) Seite mit einer ersten Folienschicht (2) auf jeder der ersten Seite des Substrats und der zweiten Seite des Substrats, wobei die ersten Folienschichten der ersten bzw. zweiten Seite des folienlaminierten Substrats entsprechend erster und zweiter Seite des Substrats entsprechen,
Bilden wenigstens einer Durchkontaktierungs-Bohrung (3), die von einer Seitenwand (12) in dem Substrat umgeben wird,
wobei die wenigstens eine Durchkontaktierungs-Bohrung gegenüberliegende erste (4) und zweite (5) Enden aufweist, wobei das erste Ende sich durch die erste Folienschicht auf der ersten Seite des folienlaminierten Substrats erstreckt,
wobei sich die wenigstens eine Durchkontaktierungs-Bohrung von ihrem ersten Ende in der ersten Folienschicht auf der ersten Seite des folienlaminierten Substrats hindurch bis zu wenigstens einer Schaltungsschicht des folienlaminierten Substrats erstreckt, und
Versenken (7) des ersten Endes der wenigstens einen Durchkontaktierungs-Bohrung auf der ersten Seite des Substrats durch wenigstens die erste Folienschicht, sodass die Seitenwand an dem ersten Ende der Durchkontaktierungs-Bohrung eine angeschrägte Oberfläche (6) aufweist, wobei das Versenken (7) der Durchkontaktierungs-Bohrung (3) einen Freiraum (16) zwischen einem äußeren Durchmesser der Versenkung und der Seitenwand der Durchkontaktierungs-Bohrung umfasst, und
Ablagern einer leitenden Schicht (15) auf der Seitenwand (12), die sich auf der angeschrägten Oberfläche (6) der wenigstens einen Durchkontaktierungs-Bohrung (3) erstreckt, sodass die leitende Schicht mit der ersten Folienschicht auf der ersten Seite des folienlaminierten Substrats ineinander greift.

2. Verfahren nach Anspruch 1, weiter umfassend:
Bilden der wenigstens einen Durchkontaktierungs-Bohrung (3) derart, dass ihr zweites Ende sich durch die erste Folienschicht (2) auf der zweiten Seite (20) des folienlaminierten Substrats (1) erstreckt, und
Versenken (7) des zweiten Endes (5) der wenigstens einen Durchkontaktierungs-Bohrung auf der zweiten Seite des Substrats durch wenigstens die erste Folienschicht, sodass die Seitenwand an dem zweiten Ende der Durchkontaktierungs-Bohrung eine angeschrägte Oberfläche (6) aufweist, wobei das Versenken (7) der Durchkontaktierungs-Bohrung (3) einen anderen Freiraum (16) zwischen einem äußeren Durchmesser der Versenkung und der Seitenwand der Durchkontaktierungs-Bohrung umfasst.

3. Verfahren nach Anspruch 1, worin die angeschrägte Seitenwandoberfläche (6) die Folienschicht (2) umfasst.

4. Verfahren nach Anspruch 1, worin das Substrat (1) mit der ersten Folienschicht (2) in einem Laminierungsschritt laminiert wird, der die Verwendung einer dielektrischen Haftschicht zwischen der Folie und dem Substrat einschließt, und die angeschrägte Seitenwandoberfläche (6) die Folienschicht und die dielektrische Haftschicht umfasst.

5. Verfahren nach Anspruch 2, weiter umfassend: Ablagern einer ersten leitfähigen Schicht (15) auf der Seitenwand (12) und beiden angeschrägten Seitenwandoberflächen (6) der wenigstens einen Durchkontaktierungs-Bohrung (3) und Füllen der wenigstens einen Durchkontaktierungs-Bohrung mit einem leitfähigen (17) oder nicht leitfähigen Material (17), um wenigstens eine gefüllte Durchkontaktierungs-Bohrung zu bilden.

6. Verfahren nach Anspruch 1, worin die erste Folienschicht (2) eine Dicke von etwa 0,01524 mm (0,0006 Zoll) besitzt und die Durchkontaktierungs-Bohrung (3) bis zu einer Tiefe von etwa 0,00254 mm (0,001 Zoll) unter Verwendung einer 130° (30)-Bohrspitze versenkt wird.

7. Verfahren nach Anspruch 1, worin die erste Folienschicht (2) eine Dicke von etwa 0,01524 mm (0,0006 Zoll) besitzt und die Durchkontaktierungs-Bohrung (3) bis zu einer Tiefe von etwa 0,00508 mm (0,002 Zoll) unter Verwendung einer 130° (30)-Bohrspitze versenkt wird.

8. Verfahren nach Anspruch 1, worin die erste Folienschicht (2) eine Dicke von etwa 0,01524 mm (0,0006 Zoll) besitzt und die Durchkontaktierungs-Bohrung (3) bis zu einer Tiefe von etwa 0,00254 mm (0,001 Zoll) unter Verwendung einer 127° (30)-Bohrspitze versenkt wird.

9. Verfahren nach Anspruch 1, worin die erste Folienschicht (2) eine Dicke von etwa 0,01524 mm (0,0006 Zoll) besitzt und die Durchkontaktierungs-Bohrung (3) bis zu einer Tiefe von etwa 0,00508 mm (0,002 Zoll) unter Verwendung einer 127° (30)-Bohrspitze versenkt wird.

10. Verfahren nach Anspruch 1, weiter umfassend:
Füllen der wenigstens einen Durchkontaktierungs-Bohrung (3) mit einem leitfähigen (17) oder nicht leitfähigen Material (17), um wenigstens eine gefüllte Durchkontaktierungs-Bohrung zu bilden, und Bilden einer leitfähigen Kappe (25) über dem ersten Ende der wenigstens einen gefüllten Durchkontaktierungs-Bohrung, wobei die leitfähige Kappe elektrisch mit der leitenden Schicht verbunden ist.

11. Verfahren nach Anspruch 10, weiter umfassend:
Bilden einer leitfähigen Kappe über dem ersten Ende der gefüllten Durchkontaktierungs-Bohrung (3), wobei die leitfähige Kappe (25) elektrisch in Kontakt mit der leitfähigen Schicht (15) ist, und
Bilden einer leitfähigen Kappe über dem zweiten Ende (5) der gefüllten Durchkontaktierungs-Bohrung, wobei die leitfähige Kappe elektrisch in Kontakt mit der leitfähigen Schicht ist, die auf der Seitenwand und der angeschrägten Seitenwandoberfläche des zweiten Endes der wenigstens einen Durchkontaktierungs-Bohrung ist.

12. Leiterplatte (PCB) mit einer ersten Seite (10) und einer zweiten Seite (20), umfassend:
eine erste Außenflächen-Leitungsschicht auf der ersten Seite des PCB und in gegenüberliegender Beziehung zu einer zweiten Außenflächen-Leitungsschicht auf der zweiten Seite des PCB,
wenigstens eine innere Leitungsschicht, die in gestapelter Formation zwischen der ersten Außenflächen-Leitungsschicht und der zweiten Außenflächen-Leitungsschicht angeordnet ist,
wenigstens eine Durchkontaktierungs-Bohrung (3),
wobei die wenigstens eine Durchkontaktierungs-Bohrung eine Seitenwand (12) aufweist, die sich zwischen einem ersten Ende (4) und einem zweiten Ende (5) erstreckt,
wobei die Seitenwand an dem ersten Ende der wenigstens einen Durchkontaktierungs-Bohrung eine angeschrägte Oberfläche (6) besitzt, eine Versenkung (7) an dem Ende der Durchkontaktierungs-Bohrung (3), wobei die Versenkung (7) einen Freiraum (16) zwischen einem äußeren Durchmesser der Versenkung und der Seitenwand der Durchkontaktierungs-Bohrung umfasst,
wobei die wenigstens eine Durchkontaktierungs-Bohrung sich von der ersten Außenflächen-Leitungsschicht des PCB hindurch zu wenigstens einer der einen oder mehreren inneren Leitungsschichten erstreckt, und
eine leitende Schicht (15) auf der Seitenwand der wenigstens einen Durchkontaktierungs-Bohrung, einschließlich der angeschrägten Oberfläche, wobei die leitende Schicht in elektrischem Kontakt ist und ineinander greift mit der ersten Außenflächen-Leitungsschicht auf der ersten Seite des PCB.

13. PCB nach Anspruch 12, worin:
die wenigstens eine Durchkontaktierungs-Bohrung (3) sich von der ersten Außenflächen-Leitungsschicht des PCB zu der und durch die zweite Außenflächen-Leitungsschicht erstreckt,
die Seitenwand (12) an dem zweiten Ende (5) der wenigstens einen Durchkontaktierungs-Bohrung eine angeschrägte Oberfläche (6) besitzt und weiter einen weiteren Freiraum (16) um das zweite Ende der wenigstens einen Durchkontaktierungs-Bohrung frei von der Außenflächen-Leitungsschicht, und
wobei die leitende Schicht (15) sich ebenfalls auf der angeschrägten Oberfläche an dem zweiten Ende der wenigstens einen Durchkontaktierungs-Bohrung befindet, wobei die leitende Schicht in elektrischem Kontakt mit der zweiten Außenflächen-Leitungsschicht ist.

14. Folienlaminiertes Substrats (1) mit erster (10) und zweiter (20) Seite, umfassend:
ein Substrat mit einem oder mehreren Schaltungsschichtpaaren in gestapelter Formation zwischen einer ersten Seite und einer zweiten Seite angeordnet, wobei die erste und zweite Seite des Substrats der ersten und zweiten Seite des folienlaminierten Substrats entsprechen,
eine erste Folienschicht (2), die auf jede der ersten und zweiten Seite des Substrats laminiert ist,
wenigstens eine Durchkontaktierungs-Bohrung (3) in dem folienlaminierten Substrat,
wobei die wenigstens eine Durchkontaktierungs-Bohrung ein erstes Ende (4) und ein zweites Ende (5) aufweist, und
wobei das erste Ende der wenigstens einen Durchkontaktierungs-Bohrung sich in der ersten Folienschicht auf der ersten Seite des folienlaminierten Substrats befindet,
wobei sich die wenigstens eine Durchkontaktierungs-Bohrung von der ersten Folienschicht auf der ersten Seite des folienlaminierten Substrats hindurch bis zu wenigstens einer Schaltungsschicht des folienlaminierten Substrats erstreckt, und wobei das erste Ende der wenigstens einen Durchkontaktierungs-Bohrung eine angeschrägte Seitenwandoberfläche aufweist, die sich zu der ersten Folienschicht erstreckt, und
eine leitende Schicht auf der angeschrägten Seitenwand-Oberfläche der wenigstens einen Durchkontaktierungs-Bohrung zum Ineinandergreifen mit der ersten Folienschicht auf der ersten Seite des folienlaminierten Substrats.

15. Folienlaminiertes Substrats nach Anspruch 14, worin:
die erste Folienschicht auf die erste (10) und zweite Seite (20) des Substrats unter Verwendung eines dielektrischen Haftmittels laminiert ist und die angeschrägte Oberfläche des ersten Endes (4) der wenigstens einen Durchkontaktierungs-Bohrung ein dielektrisches Haftmittel zusätzlich zu der Folienschicht umfasst,
die wenigstens eine Durchkontaktierungs-Bohrung sich von ihrem ersten Ende, das in der ersten Folienschicht auf der ersten Seite des folienlaminierten Substrats gebildet ist, durch die gestapelten Leitungsschichtpaare zu ihrem zweiten Ende (5) erstreckt, das in der ersten Folienschicht auf der zweiten Seite des laminierten Substrats gebildet ist, und
das zweite Ende der wenigstens einen Durchkontaktierungs-Bohrung eine angeschrägte Seitenwand-Oberfläche besitzt, die sich zu der ersten Folienschicht auf der zweiten Seite des laminierten Substrats erstreckt.

## Revendications

1. Procédé de fabrication d'une carte de circuit imprimé (PCB) comprenant :
la fourniture d'un substrat stratifié en feuille (1) possédant une ou plusieurs paires de couches de circuit empilées et comprenant un substrat possédant des premier (10) et second (20) côtés avec une première couche de feuille (2) sur chacun du premier côté du substrat et sur le second côté du substrat, les premières couches de feuille correspondant, respectivement, aux premier et second côtés du substrat stratifié en feuille correspondant aux premier et second côtés du substrat ;
la formation d'au moins un trou traversant (3) défini par une paroi latérale (12) dans le substrat ;
l'au moins un trou traversant possédant des première (4) et seconde (5) extrémités opposées, la première extrémité s'étendant à travers la première couche de feuille sur le premier côté du substrat stratifié en feuille ;
ledit au moins un trou traversant s'étendant à partir de sa première extrémité dans la première couche de feuille sur le premier côté du substrat stratifié en feuille jusqu'au moins une couche de circuit du substrat stratifié en feuille ; et
le fraisage (7) de la première extrémité de l'au moins un trou traversant sur le premier côté du substrat à travers au moins la première couche de feuille de sorte que la paroi latérale au niveau de la première extrémité du trou traversant possède une surface chanfreinée (6), ledit fraisage (7) du trou traversant (3) comprenant un jeu (16) entre un diamètre externe de la fraisure et la paroi latérale du trou traversant ; et
le dépôt d'une couche conductrice (15) sur la paroi latérale (12) s'étendant sur la surface chanfreinée (6) de l'au moins un trou traversant (3) de sorte que la couche conductrice s'imbrique avec la première couche de feuille sur le premier côté du substrat stratifié en feuille.

2. Procédé selon la revendication 1, comprenant en outre :
la formation de l'au moins un trou traversant (3) de sorte que sa seconde extrémité s'étende à travers la première couche de feuille (2) sur le second côté (20) du substrat stratifié en feuille (1) ; et le fraisage (7) de la seconde extrémité (5) de l'au moins un trou traversant sur le second côté du substrat à travers au moins la première couche de feuille de sorte que la paroi latérale au niveau de la seconde extrémité du trou traversant possède une surface chanfreinée (6), ledit fraisage (7) du trou traversant (3) comprenant un autre jeu (16) entre le diamètre externe de la fraisure et la paroi latérale du trou traversant.

3. Procédé selon la revendication 1, ladite surface de paroi latérale chanfreinée (6) comprenant la couche de feuille (2).

4. Procédé selon la revendication 1, ledit substrat (1) étant stratifié avec la première couche de feuille (2) dans une étape de stratification qui comprend l'utilisation d'une couche adhésive diélectrique entre la feuille et le substrat et ladite surface de paroi latérale chanfreinée (6) comprenant la couche de feuille et la couche adhésive diélectrique.

5. Procédé selon la revendication 2, comprenant en outre : le dépôt d'une première couche conductrice (15) sur la paroi latérale (12) et les deux surfaces de paroi latérale chanfreinées (6) de l'au moins un trou traversant (3) ; et le remplissage de l'au moins un trou traversant avec un matériau conducteur (17) ou non conducteur (17) pour former au moins un trou traversant rempli.

6. Procédé selon la revendication 1, ladite première couche de feuille (2) possédant une épaisseur d'environ 0,01524 mm (0,0006 pouces) et ledit trou traversant (3) étant fraisé à une profondeur d'environ 0,00254 mm (0,001 pouces) à l'aide d'une pointe de foret à 130 degrés (30).

7. Procédé selon la revendication 1, ladite première couche de feuille (2) possédant une épaisseur d'environ 0,01524 mm (0,0006 pouces) et ledit trou traversant (3) étant fraisé jusqu'à une profondeur d'environ 0,00508 mm (0,002 pouces) à l'aide d'une pointe de foret à 130 degrés (30).

8. Procédé selon la revendication 1, ladite première couche de feuille (2) possédant une épaisseur d'environ 0,01524 mm (0,0006 pouces) et ledit trou traversant (3) étant fraisé jusqu'à une profondeur d'environ 0,00254 mm (0,001 pouces) à l'aide d'une pointe de foret à 127 degrés (30).

9. Procédé selon la revendication 1, ladite première couche de feuille (2) possédant une épaisseur d'environ 0,01524 mm (0,0006 pouces) et ledit trou traversant (3) étant fraisé jusqu'à une profondeur d'environ 0,00508 mm (0,002 pouces) à l'aide d'une pointe de foret à 127 degrés (30).

10. Procédé selon la revendication 1, comprenant en outre :
le remplissage de l'au moins un trou traversant (3) avec un matériau conducteur (17) ou non conducteur (17) pour former au moins un trou traversant rempli ; et la formation d'un capuchon conducteur (25) sur la première extrémité de l'au moins un trou traversant rempli, le capuchon conducteur étant connecté électriquement à la couche conductrice.

11. Procédé selon la revendication 10, comprenant en outre :
la formation d'un capuchon conducteur sur la première extrémité du trou traversant rempli (3), le capuchon conducteur (25) étant électriquement en contact avec la couche conductrice (15) ; et la formation d'un capuchon conducteur sur la seconde extrémité (5) du trou traversant rempli, le capuchon conducteur étant électriquement en contact avec la couche conductrice déposée sur la paroi latérale et la surface de paroi latérale chanfreinée de la seconde extrémité de l'au moins un trou traversant.

12. Carte de circuit imprimé (PCB) possédant un premier côté (10) et un second côté (20) comprenant :
une première couche de circuit de surface externe sur le premier côté de la PCB et en relation opposée avec une seconde couche de circuit de surface externe sur le second côté du PCB ; au moins une couche de circuit interne disposée en formation empilée entre la première couche de circuit de surface externe et la seconde couche de circuit de surface externe ; au moins un trou traversant (3) ;
l'au moins un trou traversant possédant une paroi latérale (12) s'étendant entre une première extrémité (4) et une seconde extrémité (5) ;
la paroi latérale au niveau de la première extrémité de l'au moins un trou traversant possédant une surface chanfreinée (6), un fraisage (7) au niveau de l'extrémité du trou traversant (3), le fraisage (7) comprenant un jeu (16) entre un diamètre externe de la fraisure et la paroi latérale du trou traversant ;
l'au moins un trou traversant s'étendant à partir de la première couche de circuit de surface externe de la PCB jusqu'au moins l'une de la ou des couches de circuit interne ; et une couche conductrice (15) sur la paroi latérale de l'au moins un trou traversant comprenant la surface chanfreinée, la couche conductrice étant en contact électrique et imbriquée avec la première couche de circuit de surface externe sur le premier côté du PCB.

13. PCB selon la revendication 12,
ledit au moins un trou traversant (3) s'étendant à partir de la première couche de circuit de surface externe de la PCB jusqu'à la seconde couche de circuit de surface externe et à travers celle-ci ;
ladite paroi latérale (12) au niveau de la seconde extrémité (5) de l'au moins un trou traversant possédant une surface chanfreinée (6) comprenant en outre un autre jeu (16) autour de la seconde extrémité de l'au moins un trou traversant dépourvu de la second couche de circuit de surface externe ; et ladite couche conductrice (15) étant également sur la surface chanfreinée au niveau de la seconde extrémité de l'au moins un trou traversant, la couche conductrice étant en contact électrique avec la seconde couche de circuit de surface externe.

14. Substrat stratifié en feuille (1) possédant des premier (10) et second côtés (20) comprenant :
un substrat possédant une ou plusieurs paires de couches de circuit en formation empilée disposées entre un premier côté et un second côté, les premier et second côtés du substrat correspondant aux premier et second côtés du substrat stratifié en feuille ;
une première couche de feuille (2) stratifiée sur chacun des premier et second côtés du substrat ;
au moins un trou traversant (3) dans le substrat stratifié en feuille ;
ledit au moins un trou traversant possédant une première extrémité (4) et une seconde extrémité (5) et ; la première extrémité de l'au moins un trou traversant étant dans la première couche de feuille sur le premier côté du substrat stratifié en feuille ;
ledit au moins un trou traversant s'étendant à partir de la première couche de feuille sur le premier côté du substrat stratifié en feuille jusqu'au moins une couche de circuit du substrat stratifié en feuille ;
et la première extrémité de l'au moins un trou traversant possédant une surface de paroi latérale chanfreinée qui s'étend jusqu'à la première couche de feuille ; et
une couche conductrice sur la surface de la paroi latérale chanfreinée de l'au moins un trou traversant pour s'imbriquer avec la première couche de feuille sur le premier côté du substrat stratifié en feuille.

15. Substrat stratifié en feuille selon la revendication 14,
ladite première couche de feuille étant stratifiée sur les premier (10) et second côtés (20) du substrat au moyen d'un adhésif diélectrique et ladite surface chanfreinée au niveau de la première extrémité (4) de l'au moins un trou traversant comprenant un adhésif diélectrique en plus de la couche de feuille ; ledit au moins un trou traversant s'étendant à partir de sa première extrémité formée dans la première couche de feuille sur le premier côté du substrat stratifié en feuille, à travers les paires de couches de circuit empilées, jusqu'à sa seconde extrémité (5) formée dans la première couche de feuille sur le second côté du substrat stratifié ; et la seconde extrémité de l'au moins un trou traversant possédant une surface de paroi latérale chanfreinée qui s'étend jusqu'à la première couche de feuille sur le second côté du substrat stratifié.
